# EUROPÄISCHE PATENTSCHRIFT

(11) **EP 3 428 000 B1**
(45) Veröffentlichungstag und Bekanntmachung des Hinweises auf die Patenterteilung: **02.06.2021**
(21) Anmeldenummer: 18020058.6
(22) Anmeldetag: 13.02.2018
(51) Int. Cl.: H02J 7/02, B60L 53/10, B60L 53/14, B60L 53/18, B60L 53/302, B60L 53/30, H02J 7/00, B60L 53/31

(54) **VORRICHTUNG ZUM LADEN MINDESTENS EINER BATTERIE**
DEVICE FOR CHARGING AT LEAST ONE BATTERY
DISPOSITIF DE CHARGEMENT D'AU MOINS UNE BATTERIE

(30) Priorität: 12.07.2017 DE 102017115631
(43) Veröffentlichungstag der Anmeldung: 16.01.2019
(73) Patentinhaber: Dr. Ing. h.c. F. Porsche AG, 70435 Stuttgart (DE)
(72) Erfinder: Götz, Stefan, 85659 Forstern (DE); Köhler, David, 74321 Bietigheim-Bissingen (DE); Heyne, Raoul, 38640 Goslar (DE); Reber, Volker, 74544 Michelbach/Bilz (DE); Basha, Bekim, 74321 Bietigheim-Bissingen (DE); Roggendorf, Christoph, 71706 Markgröningen (DE); Hähre, Karsten, 67373 Dudenhofen (DE); Kiefer, Michael, 70563 Stuttgart (DE); Zander, Steve, 71672 Marbach/Neckar (DE); Zies, Camila, 70178 Stuttgart (DE); Metzger, Christian, 71732 Tamm (DE)

(56) Entgegenhaltungen:
- EP-A2- 2 572 431
- EP-A2- 2 665 152
- DE-A1-102015 110 023
- DE-T5-112012 003 099
- GB-A- 2 536 653
- US-A1- 2008 002 364
- US-A1- 2016 270 257
- R Anzalone ET AL: "Interface state density evaluation of high quality hetero-epitaxial 3C-SiC(001) for high-power MOSFET applications", Materials Science & Engineering B, 1. August 2015 (2015-08-01), Seiten 14-19, XP055491380, DOI: 10.1016/j.mseb.2015.03.014 Gefunden im Internet: URL:http://www.how2power.com/newsletters/1 610/products/H2PToday1610_products_Wolfspe ed.pdf?NOREDIR=1 [gefunden am 2018-07-10]
- Christian Will ET AL: "Understanding user acceptance factors of electric vehicle smart charging", Transportation Research Part C, 1. Oktober 2016 (2016-10-01), Seiten 198-214, XP055491439, DOI: 10.1016/j.trc.2016.07.006 Gefunden im Internet: URL:http://www.electway.net/upload/file/14 00741992.pdf [gefunden am 2018-07-10]
- Setec-Power.Com: "Electric Car Solar Mppt Fast Charging Station 50kw - Buy Ev Fast Dc Charging Station,50kw Fast Charging Station,50kw Solar Charging Station Product on Alibaba.com", see Declaration of conformity regarding date, 25. Dezember 2015 (2015-12-25), XP055491469, Gefunden im Internet: URL:https://www.alibaba.com/product-detail /electric-car-solar-MPPT-fast-charging_604 76457940.html [gefunden am 2018-07-10]

## Beschreibung

Die Erfindung betrifft eine Vorrichtung zum Laden mindestens einer Batterie, insbesondere für Fahrzeuge mit Elektroantrieb.

Die GB 2 536 653 A zeigt eine Gleichstrom-Energieversorgung mit einem Gleichrichter und einer Mehrzahl von Gleichstrom-Ausgangsstufen für das Laden von Batterien mit hoher Ladeleistung.

Die US 5,594,315 zeigt ein Induktionsladegerät zum Laden einer Batterie. Das Induktionsladegerät hat eine Primärwicklung, welche zur Erzeugung eines magnetischen Flusses an eine Spannungsquelle angeschlossen ist, und es hat Kühlleitungen, welche von einem durch eine Pumpe geförderten flüssigen Kühlmittel zur Kühlung des Induktionsladegeräts durchströmt werden.

Die US 6,396,241 B1 zeigt eine induktive Ladekupplung, die über ein Stromkabel mit Strom versorgt wird. Eine Kühlmittelleitung verläuft über das Stromkabel zur Ladekupplung und kann somit die Ladekupplung und das Stromkabel kühlen.

Die WO 2010/114454 A1 zeigt eine Anlage zur Batterieladung, welche an ein Stromnetz mit einer Spannung von bis zu 54 kV angeschlossen ist.

Die WO 2014/009369 A2 zeigt eine Gleichstrom-Schnellladestation mit modularem Aufbau.

Die DE 10 2015 110 023 A1 zeigt eine Ladestation zum Laden eines Plug-In-Kraftfahrzeugs an einer Ladesäule, welche Ladestation einen Leistungstransformator, Gleichrichtermodule, Step-Down-DC/DC-Wandler und Ladesäulen aufweist.

Die EP 2 665 152 A2 zeigt einen Transformator mit einer Mehrzahl von dreiphasigen Sekundärwicklungsanordnungen.

Die US 2016 / 270 257 A1 zeigt einen Lader mit einem integrierten oder mit einem externen aktiven Kühlsystem.

Die US 2008/0002364 A1 zeigt eine Kühlmittelsteuereinheit und ein gekühltes Elektroniksystem, bei dem ein Kühlmittelkreislauf in einem Versorgungsverteiler in mehrere Leitungen aufgeteilt wird, welche Leitungen zur Kühlung mehrerer Elektronik-Racks vorgesehen sind, und welche Leitungen über einen Rücklaufverteiler wieder zusammengeführt, anschließend gepumpt und gekühlt werden.

Die EP 2 572 431 A2 zeigt ein Ladesystem für Elektrofahrzeuge, welches einen Leistungsumwandler aufweist.

Es besteht das allgemeine Bestreben, Elektrofahrzeuge schnell aufzuladen, und hierfür sind hohe Ladeleistungen erforderlich, die eine hohe Anforderung an die Ladevorrichtung stellen. Eine aktuelle Norm hierzu ist IEC 61851-23, Mode 4, Abschnitt CC. Hohe Ladeleistungen sind erwünscht.

Es ist daher eine Aufgabe der Erfindung, eine neue Vorrichtung zum Laden von Batterien bereit zu stellen.

Die Aufgabe wird gelöst durch eine Vorrichtung gemäß Anspruch 1.

Die räumliche Trennung des Elektronikmoduls und der Ladesäule ermöglicht einen modularen Aufbau, und die Ladesäule kann schlank ausgebildet werden. Zudem kann die Ladesäule geräuscharm ausgebildet werden, da die Kühlung der Leistungselektronik nicht direkt in der Ladesäule erfolgen muss.

Gemäß einer bevorzugten Ausführungsform ist die mindestens eine Leistungselektronikeinheit dazu ausgebildet, genau einen Ladepunkt mit einer Gleichspannung zu versorgen. Dies ermöglicht eine nicht allzu große Leistungselektronikeinheit und eine Erweiterung mit Leistungselektronik-Untereinheiten nach Bedarf.

Gemäß einer bevorzugten Ausführungsform weist die mindestens eine Leistungselektronikeinheit Halbleiterschalter auf, welche als Siliziumkarbid-Halbleiterschalter ausgebildet sind. Auf Grund der guten Schalteigenschaften und der geringen Verluste sind diese Halbleiterschalter vorteilhaft, um einen geringen Bauraum und wenig Verlustleistung zu ermöglichen.

Gemäß einer bevorzugten Ausführungsform weist die mindestens eine Leistungselektronikeinheit Halbleiterschalter auf, welche als Gallium-Nitrid-Halbleiterschalter ausgebildet sind. Auf Grund der guten Schalteigenschaften und der geringen Verluste sind diese Halbleiterschalter vorteilhaft, um einen geringen Bauraum und wenig Verlustleistung zu ermöglichen. Zudem benötigen sie wenig Bauraum.

Gemäß einer bevorzugten Ausführungsform sind der AC/DC-Wandler und der DC/DC-Wandler ohne galvanische Trennung ausgebildet. Dies verringert die Verlustleistung, und Messungen haben einen um ca. 1 % höheren Wirkungsgrad ergeben.
Gemäß einer bevorzugten Ausführungsform beträgt der Wirkungsgrad der Leistungselektronikeinheit zumindest zeitweise mindestens 97 %. Hierdurch wird die erforderliche Kühlleistung für die Kühlung der Leistungselektronikeinheit verringert. Die 97 % können insbesondere in Betriebspunkten erzielt werden, die dem Nennbetrieb entsprechen.

Gemäß einer bevorzugten Ausführungsform ist das Elektronikmodul in einem Elektronikmodul-Gehäuse angeordnet, dessen Höhe (H) kleiner als 1,5 m ist, bevorzugt kleiner als 1,35 m. Für einen Transport hat sich diese maximale Gehäusehöhe als besonders vorteilhaft erwiesen.

Gemäß einer bevorzugten Ausführungsform weist das Elektronikmodul eine Mehrzahl von Leistungselektronik-Untereinheit-Aufnahmen auf, welche Leistungselektronik-Untereinheit-Aufnahmen jeweils zur Anordnung einer Leistungselektronik-Untereinheit ausgebildet sind. Das Elektronikmodul ist auch verwendbar, wenn nur in einer Leistungselektronik-Untereinheit-Aufnahme eine Leistungselektronik-Untereinheit angeordnet ist oder nur eine Leistungselektronik-Untereinheit verfügbar ist, bzw. wenn in einem Teil der Leistungselektronik-Untereinheit-Aufnahmen keine Leistungselektronik-Untereinheit angeordnet ist. Für einen modularen Aufbau hat sich diese Ausbildung als vorteilhaft erwiesen, da für eine Leistungselektronikeinheit in Abhängigkeit von der maximalen Ladeleistung eine unterschiedliche Anzahl an Leistungselektronik-Untereinheiten verwendet werden kann, und dabei keine ungenutzten Leistungselektronik-Untereinheiten vorgesehen werden müssen.

Gemäß einer bevorzugten Ausführungsform sind die Leistungselektronik-Untereinheiten als Einschübe ausgebildet.

Gemäß einer bevorzugten Ausführungsform weist das Elektronikmodul ein Elektronikmodul-Gehäuse auf, welches Elektronikmodul-Gehäuse an einer Seite einen Elektronikmodul-Gehäusezugang aufweist, über welchen die Aufnahmen für die Leistungselektronik-Untereinheiten zugänglich sind, um eine Wartung zu ermöglichen. Die Wartung kann somit von einer Seite aus erfolgen, ohne dass das gesamte Gehäuse entfernt werden muss.

Gemäß einer bevorzugten Ausführungsform weist das Kühlmodul ein Kühlmodul-Gehäuse auf, welches Kühlmodul-Gehäuse an einer Seite einen Kühlmodul-Gehäusezugang aufweist, um eine Wartung zu ermöglichen.

Gemäß einer bevorzugten Ausführungsform weist das Transformatormodul ein Transformatormodul-Gehäuse auf, welches Transformatormodul-Gehäuse an einer Seite einen Transformatormodul-Gehäusezugang aufweist, um eine Wartung zu ermöglichen.

Gemäß einer bevorzugten Ausführungsform ist die mindestens eine Leistungselektronikeinheit dazu ausgebildet, die Versorgung eines Ladepunkts mit einer maximalen Ladeleistung zu ermöglichen, welche maximale Ladeleistung mindestens 60 kW beträgt, bevorzugt mindestens 300 kW beträgt, besonders bevorzugt mindestens 420 kW. Die Auslegung der Vorrichtung und der Leistungselektronikeinheiten ist für hohe Ladeleistungen, und hierfür konnte ein modularer Aufbau und optional auch eine schlanke Ausgestaltung der Gehäuse erzielt werden.

Gemäß einer bevorzugten Ausführungsform weist die Vorrichtung ein Transformatormodul mit einem Transformator auf. Das Transformatormodul kann für mehrere Elektronikeinheiten verwendet werden.

Gemäß einer bevorzugten Ausführungsform ist das Transformatormodul räumlich getrennt vom Elektronikmodul. Für den modularen Aufbau hat sich diese Ausgestaltung als vorteilhaft erwiesen, da das Transformatormodul unabhängig von der Anzahl der Elektronikmodule gleich ausgestaltet werden kann.

Gemäß einer bevorzugten Ausführungsform weist der Transformator eine Primärwicklung und mehrere voneinander galvanisch getrennte dreiphasige Sekundärwicklungssysteme in Stern- oder Dreieckskonfiguration auf, welche jeweils genau einer Leistungselektronikeinheit zugeordnet sind. Hierdurch kann mit geringer Verlustleistung eine galvanische Trennung zwischen,den an unterschiedlichen Sekundärwicklungssystemen angeschlossenen Leistungselektronikeinheiten erzielt werden.

Gemäß einer bevorzugten Ausführungsform weist das Gesamtsystem, welches den Transformator umfasst, einen höhen Gleichzeitigkeitsfaktor auf, der größer als 0,85 ist, bevorzugt größer als 0,9 ist und besonders bevorzugt 1,0 ist. Ein solcher Transformator ermöglicht eine sehr effiziente Vorrichtung und damit einen geringen Bauraum der einzelnen Module.

Gemäß einer bevorzugten Ausführungsform weist das Transformatormodul ein Transformatormodul-Gehäuse auf, und das Elektronikmodul weist ein Elektronikmodul-Gehäuse auf, wobei das Transformatormodul-Gehäuse und das Elektronikmodul-Gehäuse die gleiche Form und die gleichen Abmessungen aufweisen. Dies erleichtert die Logistik beim Transport der Module.

Die Vorrichtung weist ein Kühlmodul auf, welches Kühlmodul dazu ausgebildet ist, ein flüssiges Kühlmittel in einem Kühlmittelkreislauf zu fördern. Über ein flüssiges Kühlmittel kann der modulare Aufbau besonders gut gekühlt werden, da Flüssigkeiten eine hohe Wärmekapazität haben.

Gemäß einer bevorzugten Ausführungsform sind das Kühlmodul und das Elektronikmodul räumlich voneinander getrennt sind. Die Platzierung und der Transport der Module werden hierdurch erleichtert.

Gemäß einer bevorzugten Ausführungsform ist das Kühlmodul fluidtechnisch mit dem Elektronikmodul verbunden, um eine Kühlung des Elektronikmoduls zu ermöglichen. Dies verringert die Wege für die Kühlleitungen und erleichtert die Trennung des Kühlmittelflusses durch die einzelnen Zweige des Kühlkreislaufs.

Gemäß einer bevorzugten Ausführungsform ist das Elektronikmodul fluidtechnisch mit mindestens einer Ladesäule verbunden, um einen Kühlmittelfluss vom Elektronikmodul zur Ladesäule und bevorzugt auch von der Ladesäule zurück zum Elektronikmodul zu ermöglichen. Auch dies verringert die Wege für die Kühlleitungen und erleichtert die fluidtechnische Verschaltung.

Gemäß einer bevorzugten Ausführungsform weist die mindestens eine Ladesäule ein Ladekabel und einen Wärmetauscher auf, und das Kühlmodul ist fluidtechnisch mit dem Wärmetauscher der mindestens einen Ladesäule verbunden, um mit Hilfe des Wärmetauschers eine Kühlung des Ladekabels zu ermöglichen. Hierdurch wird im Gesamtsystem eine vorteilhafte Kühlung im Bereich der Ladesäule ermöglicht.

Gemäß einer bevorzugten Ausführungsform ist das Kühlmodul fluidtechnisch derart mit einer Leistungselektronikeinheit und einer dieser Leistungselektronikeinheit zugeordneten Ladesäule verbunden, dass ein Kühlmittelkreislauf vom Kühlmodul über die Ladesäule und über die der Ladesäule zugeordnete Leistungselektronikeinheit zurück zum Kühlmodul ermöglicht ist. Dies ergibt eine funktionale Einheit, und wenn das Kühlmodul funktioniert, werden die Leistungselektronikeinheit und die zugehörige Ladesäule gekühlt und können daher genutzt werden. Der Kühlmittelkreislauf kann auch in umgekehrter Reihenfolge ausgebildet werden.

Das Kühlmodul weist mindestens zwei Kühleinheiten auf, welche jeweils einem separaten Kühlmittelkreislauf zugeordnet sind. Wenn eine dieser Kühleinheiten ausfällt, kann über die Kühlung der anderen Kühleinheit immer noch ein Teil der Ladesäulen genutzt werden. Zudem kann ein Kühleinheit-Gehäuse mit den bevorzugten Abmessungen mindestens zwei Kühleinheiten aufnehmen, bevorzugt genau zwei Kühleinheiten.

Die mindestens zwei Kühleinheiten sind fluidtechnisch mit unterschiedlichen Ladesäulen und Leistungselektronikeinheiten verbunden, um beim Ausfall einer der mindestens zwei Kühleinheiten die Kühlung von zumindest einem Teil der Leistungselektronikeinheiten und Ladesäulen zu ermöglichen.

Gemäß einer bevorzugten Ausführungsform ist jede der mindestens zwei Kühleinheiten für maximal drei Leistungselektronikeinheiten und Ladepunkte ausgebildet. Für den modularen Aufbau hat sich diese Anzahl als besonders geeignet erwiesen.

Gemäß einer bevorzugten Ausführungsform ist das Kühlmodul in einem Kühlmodul-Gehäuse angeordnet, dessen Höhe kleiner als 1,5 m ist, bevorzugt kleiner als 1,35 m. Für den Transport und die Lagerlogistik ist dies sehr vorteilhaft geeignet.

Gemäß einer bevorzugten Ausführungsform weist das Kühlmodul ein Kühlmodul-Gehäuse auf, und das Elektronikmodul ein Elektronikmodul-Gehäuse, wobei das Kühlmodul-Gehäuse und das Elektronikmodul-Gehäuse die gleiche Form und die gleichen Abmessungen aufweisen. Dies erleichtert die Logistik beim Transport der Module.

Das Kühlmodul ist fluidtechnisch mit mindestens zwei parallel geschalteten Leistungselektronikeinheiten zu einem Kühlmittelkreislauf geschaltet, wobei steuerbare Durchflusssteuerungsmittel vorgesehen sind, um die Kühlleistung für die mindestens zwei parallel geschalteten Leistungselektronikeinheiten im Verhältnis zueinander beeinflussen zu können. Hierdurch kann die maximal erforderliche Kühlleistung niedriger angesetzt werden, da nicht andauernd alle Ladepunkte besetzt oder mit voller Ladeleistung geladen werden. Mit den Durchflusssteuerungsmitteln kann die vorhandene Kühlleistung besser genutzt werden.

Weitere. Einzelheiten und vorteilhafte Weiterbildungen der Erfindung ergeben sich aus den im Folgenden beschriebenen und in den Zeichnungen dargestellten, in keiner Weise als Einschränkung der Erfindung zu verstehenden Ausführungsbeispielen sowie aus den Unteransprüchen. Es zeigt
Fig. 1 in einer schematischen Draufsicht eine Ladestation mit einer Ladesäule,
Fig. 2 in einer schematischen Draufsicht eine Ladestation mit zwei Ladesäulen,
Fig. 3 in einer schematischen Draufsicht eine Ladestation mit sechs Ladesäulen,
Fig. 4 in einer raumbildlichen Darstellung ein Elektronikmodul mit
Leistungselektronikeinheit und integrierter Kühleinheit,
Fig. 5 in einer raumbildlichen Darstellung das Elektronikmodul von Fig. 4 ohne Seitenwände,
Fig. 6 in einer schematischen Darstellung das Elektronikmodul von Fig. 4,
Fig. 7 in einer raumbildlichen Darstellung ein Elektronikmodul mit zwei Leistungselektronikeinheiten,
Fig. 8 in einer raumbildlichen Darstellung das Elektronikmodul von Fig. 7 ohne Seitenwände,
Fig. 9 in einer schematischen Darstellung das Elektronikmodul von Fig. 7,
Fig. 10 in einer raumbildlichen Darstellung ein Kühlmodul mit zwei Kühleinheiten,
Fig. 11 in einer raumbildlichen Darstellung das Kühlmodul von Fig. 10 ohne Seitenwände,
Fig. 12 in einer schematischen Darstellung das Kühlmodul von Fig. 10,
Fig. 13 in einer schematischen Darstellung eine Leistungselektronikeinheit,
Fig. 14 in einer schematischen Darstellung einen elektrischen Schaltplan der Ladestation,
Fig. 15 in einer schematischen Darstellung eine Ladesäule, und
Fig. 16 in einer schematischen Darstellung den fluidtechnischen Schaltplan für die Kühlung der Ladestation.

Die Vorrichtung bzw. Ladestation kann an einem Parkplatz mit Lademöglichkeit vorgesehen werden, es kann aber auch eine Elektrotankstelle eingerichtet werden, die beispielsweise wie eine Autobahntankstelle an einer Autobahn gelegen ist.

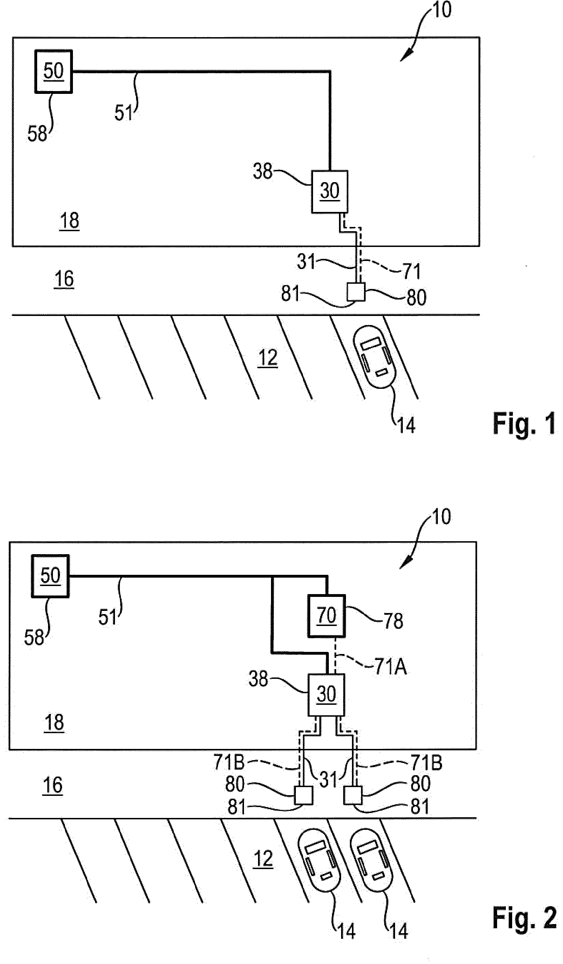

**Fig. 1** zeigt eine Vorrichtung 10 zum Laden einer Batterie eines Fahrzeugs 14, insbesondere zum Laden einer Traktionsbatterie. Schematisch sind Parkplätze 12 gezeigt, auf denen ein Fahrzeug 14 oder mehrere Fahrzeuge 14 geparkt werden können. Beispielhaft ist ein Gehweg 16 vorgesehen, und auf der von den Parkplätzen 12 abgewandten Seite des Gehwegs 16 ist eine Fläche 18 vorgesehen, bspw. eine Schotterfläche oder eine Gartenanlage.

Die Vorrichtung 10 hat ein Transformatormodul 50, welches über eine elektrische Leitung 51 mit einem Elektronikmodul 30 verbunden ist. Das Elektronikmodul 30 ist über eine elektrische Leitung 31 und über eine Kühlmittelleitung 71 mit einer Ladesäule 80 verbunden. Die Kühlmittelleitung 71 ist gestrichelt dargestellt. Die Ladesäule 80 hat einen Ladepunkt 81. Das Elektronikmodul 30 und die Ladesäule 80 sind räumlich voneinander getrennt, und dies ist vorteilhaft, da die Ladesäule 80 durch die Trennung vom Elektronikmodul 30 schlank ausgeführt werden kann, also vergleichsweise geringen Bauraum benötigt. Zudem erfordern Elektronikmodule 30 bei hohen Ladeleistungen eine Kühlung, die zu Geräuschen führen kann. Die getrennte Aufstellung des Elektronikmoduls 30 ermöglicht somit eine Ladesäule 80, die nur geringe oder überhaupt keine Störgeräusche erzeugt.

Das Elektronikmodul 30 hat ein Elektronikmodul-Gehäuse 38, und das Transformatormodul hat ein Transformatormodul-Gehäuse 58. Das Transformatormodul-Gehäuse 58 und das Elektronikmodul-Gehäuse 38 haben bevorzugt die gleiche Form und die gleichen Abmessungen, wie dies durch die gleiche Größe der schematisch dargestellten Module angedeutet ist. Das Transformatormodul-Gehäuse 58 und das Elektronikmodul-Gehäuse 38 sind bevorzugt quaderförmig ausgebildet, es kann aber bspw. auch eine säulenförmige Ausbildung oder eine Ausbildung mit sechseckigem Querschnitt gewählt werden.

Das Elektronikmodul 30 ist im Ausführungsbeispiel zusätzlich zur Kühlung ausgebildet, wobei sowohl eine Kühlung des Elektronikmoduls 30 als auch eine Kühlung der Ladesäule 80 über die Kühlmittelleitung 71 möglich ist.

**Fig. 2** zeigt ein Ausführungsbeispiel der Vorrichtung 10 mit zwei Ladesäulen 80. Im Unterschied zu Fig. 1 ist ein separates Kühlmodul 70 vorgesehen. Das Transformatormodul 50 versorgt über eine Leitung 51 sowohl das Kühlmodul 70 als auch das Elektronikmodul 30 mit elektrischer Energie. Das Elektronikmodul 30 versorgt über elektrische Leitungen 31 beide Ladesäulen 80 mit Strom. Das Kühlmodul 70 ist über eine Kühlmittelleitung 71A mit dem Elektronikmodul 30 verbunden, um einen Kühlmittelfluss zum Elektronikmodul 30 oder einen Kühlmittelfluss vom Elektronikmodul 30 und bevorzugt einen Kühlmittelfluss in beide Richtungen zu ermöglichen. Das Elektronikmodul 30 ist über Kühlmittelleitungen 71B mit den Ladesäulen 80 verbunden und ermöglicht somit eine Zuführung des Kühlmittels zu den Ladesäulen 80 oder von den Ladesäulen 80. Bevorzugt ermöglichen die Kühlmittelleitungen 71B auch einen Rückfluss des Kühlmittels von den Ladesäulen 80 zum Elektronikmodul 30 oder umgekehrt.

Auch hier ist das Elektronikmodul 30 von den Ladesäulen 80 getrennt angeordnet.

Das Kühlmodul 70 hat ein Kühlmodul-Gehäuse 78, und die Form und die Abmessungen des Kühlmodul-Gehäuses 78 entsprechen bevorzugt der Form und den Abmessungen des Transformatormodul-Gehäuses 58 und bevorzugt auch des Elektronikmodul-Gehäuses 38.

Die gleiche Ausbildung der Gehäuse erleichtert erheblich den Transport der Module, da die Gehäuse bspw. in einem Lastkraftwagen beliebig kombiniert werden können.

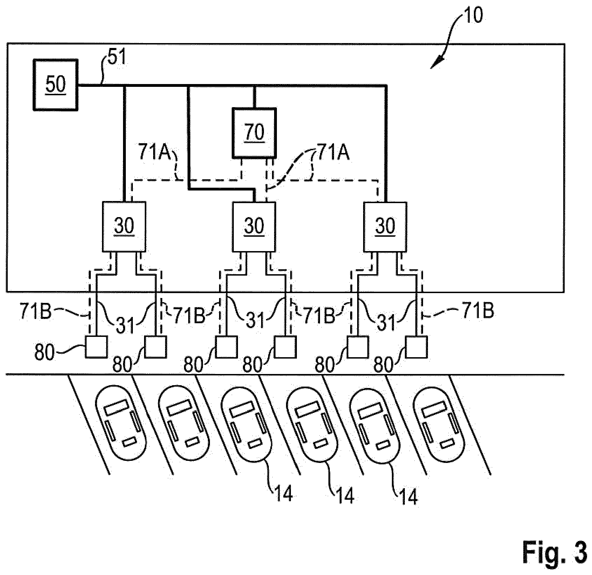

**Fig. 3** zeigt die Vorrichtung 10 in einer größeren Ausbaustufe. Es sind sechs Ladesäulen 80 vorgesehen, wobei jeweils zwei Ladesäulen 80 von einem Elektronikmodul 30 über elektrische Leitungen 31 gespeist werden. Das Transformatormodul 50 ist über elektrische Leitungen 51 mit dem Kühlmodul 70 und mit den Elektronikmodulen 30 verbunden, um diese mit elektrischer Energie zu versorgen. Das Kühlmodul 70 ist über Leitungen 71A mit den Elektronikmodulen 30 verbunden, um diesen Kühlmittel zuzuführen. Das Kühlmodul 70 ist somit als zentrales Kühlmodul 70 für eine Mehrzahl von Elektronikmodulen 70 eingesetzt. Die Elektronikmodule 30 sind über Kühlmittelleitungen 71B mit den Ladesäulen 80 verbunden, um einen Kühlmittelfluss zwischen den Elektronikmodulen 30 und den Ladesäulen 80 zu ermöglichen.

Wie aus Fig. 1 bis Fig. 3 ersichtlich ist, kann mit den Elektronikmodulen 30 und dem Kühlmodul 70 ein modularer Aufbau der Vorrichtung 10 in unterschiedlichen Ausbaustufen erreicht werden. Die Ausbildung von Fig. 3 mit dem Kühlmodul 70, den Elektronikmodulen 30 und den Ladesäulen 80 kann verdoppelt werden, um eine Vorrichtung mit zwölf Ladesäulen zu ermöglichen, und entsprechend kann auch jede andere Zahl von einem bis zwölf Ladesäulen 80 bzw. Ladepunkten 81 modular verwirklicht werden.

Bevorzugt ist eine zentrale Ladeparksteuerung bzw. Steuerung der Vorrichtung 10 vorgesehen, und diese kann beispielsweise im Transformatormodul 50 angeordnet werden.

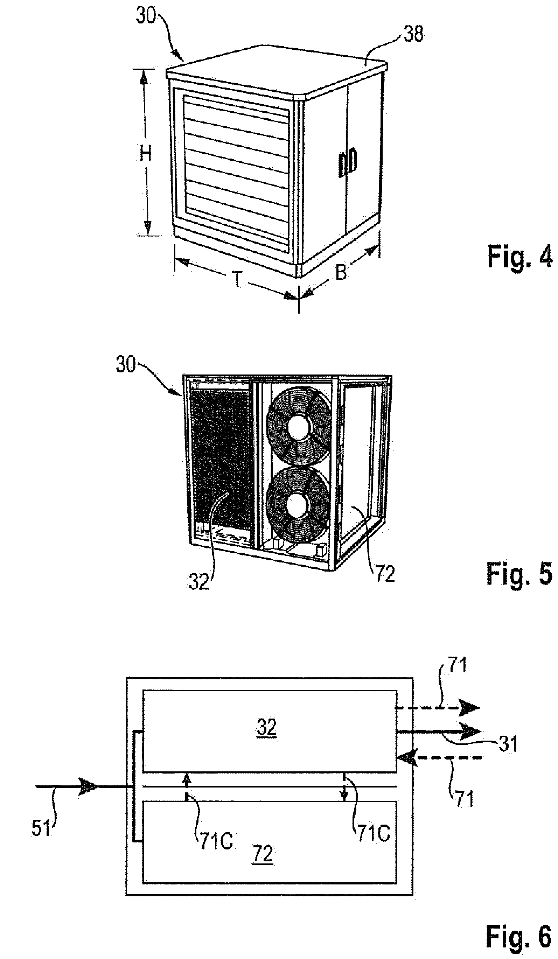

**Fig. 4** zeigt eine Ausführungsform des Elektronikmoduls 30 mit einem Elektronikmodul-Gehäuse 38. Das Elektronikmodul-Gehäuse 38 ist quaderförmig aufgebaut, und es sind die Breite B, die Tiefe T und die Höhe H eingezeichnet.

Bevorzugt ist die Höhe H kleiner als 1,5 m, weiter bevorzugt kleiner als 1,35 m. Diese Höhenbeschränkung hat sich als vorteilhaft für den Transport des Elektronikmodul-Gehäuses 38 erwiesen. Zudem entfällt in manchen Regionen bei einer solchen Höhe die Notwendigkeit einer Baugenehmigung. Auch für den Gebrauch ist ein solches Gehäuse mit überschaubarer Größe vorteilhaft. Die Breite B liegt bevorzugt im Bereich 1,0 bis 1,4 m, weiter bevorzugt im Bereich 1,1 m bis 1,3 m und besonders bevorzugt 1,2 m. Die Tiefe T liegt bevorzugt im Bereich 0,4 m bis 0,8 m, weiter bevorzugt im Bereich 0,5 m bis 0,7 m, und besonders bevorzugt beträgt sie 0,6 m. Insbesondere für einen Transport mit einem LKW sind diese Maße vorteilhaft. Die Ladefläche eines LKW hat häufig eine Breite von 2,44 m und eine Höhe von 2,26 m.

**Fig. 5** zeigt das Elektronikmodul 30 von Fig. 4 ohne Außenwand. Im Elektronikmodul 30 sind eine Leistungselektronikeinheit 32 und eine Kühleinheit 72 vorgesehen. Die Kühleinheit 72 kühlt beispielhaft mit Hilfe von zwei Gebläsen.

**Fig. 6** zeigt in schematischer Darstellung den Aufbau des Elektronikmoduls 30. Im Elektronikmodul 30 sind eine Leistungselektronikeinheit 32 und eine Kühleinheit 72 vorgesehen. Beide Einheiten werden über eine elektrische Leitung 51 mit elektrischer Energie gespeist. Die Kühleinheit 72 ist über Kühlmittelleitungen 71C mit der Leistungselektronikeinheit 32 verbunden und ermöglicht so eine Kühlung der Leistungselektronikeinheit 32. Die Leistungselektronikeinheit 32 hat eine elektrische Leitung 31 zur Stromversorgung einer Ladesäule 80. Zudem gehen Kühlmittelleitungen 71 von der Leistungselektronikeinheit 32 aus in Richtung zur Ladesäule 80, um einen Kühlmittelfluss zur Ladesäule 80 und von dieser zurück zu ermöglichen. Bevorzugt sind die Anschlüsse für die elektrischen Leitungen 51, 31 und die Kühlmittelleitungen 71 alle an einer Seite des Gehäuses angeordnet und dort zugänglich, bevorzugt an der Vorderseite hinter dem Gehäusezugang.

Die Leistungselektronikeinheit 32 ist bevorzugt dazu ausgebildet, genau einen Ladepunkt 81 mit einer Gleichspannung zu versorgen. Dabei besteht die Möglichkeit, dass über die Leistungselektronikeinheit 32 wahlweise ein erster Ladepunkt 81 oder ein zweiter Ladepunkte 81 versorgt wird, nicht jedoch beide gleichzeitig. Dies kann z.B. vorteilhaft sein, wenn an einem Parkplatz zwei Ladepunkte vorgesehen sind, die abhängig von der Parkposition ausgewählt werden können. Durch diese alternative Doppelnutzung können Kosten für die Leistungselektronikeinheit gespart werden.

Bevorzugt ist an einer Ladesäule 80 genau ein Ladepunkt 81 vorgesehen.

Das Vorsehen einer Leistungselektronikeinheit 32 und einer Kühleinheit 72 in einem Elektronikmodul 30 ist bei einem kleinen Ausbau der Vorrichtung 10, wie er in Fig. 1 gezeigt ist, vorteilhaft, da das Elektronikmodul-Gehäuse 38 räumlich gut ausgenutzt wird.

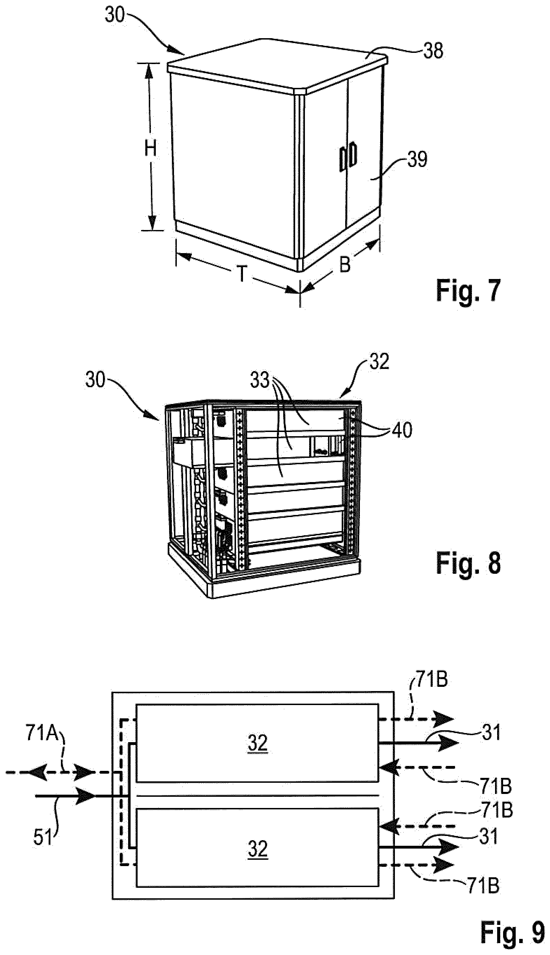

**Fig. 7** zeigt eine weitere Ausführungsform des Elektronikmoduls 30 mit dem Elektronikmodul-Gehäuse 38. Für die Form und die Abmessungen des Elektronikmodul-Gehäuses 38 gelten die Ausführungen zu Fig. 4. Das Elektronikmodul-Gehäuse 38 hat einen Elektronikmodul-Gehäusezugang 39 an einer Seite des Elektronikmodul-Gehäuses 38. Über diesen Elektronikmodul-Gehäusezugang 39 können bevorzugt Leistungselektronikeinheiten 32 montiert oder entnommen werden, und es kann eine Wartung durchgeführt werden.

**Fig. 8** zeigt das Elektronikmodul 30 von Fig. 7, jedoch ohne Außenwände. Dargestellt ist eines der beiden Elektronikmodule 32. Das Elektronikmodul 32 hat eine Mehrzahl von Aufnahmen 40, und in diese Aufnahmen 40 können bspw. Leistungselektronik-Untereinheiten 33 eingeschoben werden. Jede der Leistungselektronik-Untereinheiten 33 ermöglicht beispielsweise eine maximale Ladeleistung von 60 kW. Die Ladeleistungen der Leistungselektronik-Untereinheiten addieren sich, so dass die Leistungselektronikeinheit 32 bei einer Leistungselektronik-Untereinheit 33 eine maximale Ladeleistung von 60 kW hat, und bei sechs Leistungselektronik-Untereinheiten 33 eine maximale Ladeleistung von 360 kW. Im Ausführungsbeispiel sind maximal sieben Leistungselektronik-Untereinheiten 33 für jede Leistungselektronikeinheit 32 einsetzbar. Hierdurch können nach Bedarf Leistungselektronik-Untereinheiten 33 eingesetzt werden. Dies ermöglicht einen modularen Aufbau dahingehend, dass Leistungselektronik-Untereinheiten 33 nur dann eingesetzt werden müssen, wenn sie für eine entsprechende Ladesäule 80 benötigt werden. Bevorzugt ist die jeweilige Leistungselektronikeinheit 32 auch dann verwendbar, wenn nur in einem Teil der Leistungselektronik-Untereinheit-Aufnahmen 40 Leistungselektronik-Untereinheiten 33 angeordnet sind. Die Leistungselektronik-Untereinheiten 33 können bspw. als Einschübe, insbesondere als 19 Zoll-Einschübe ausgebildet werden.

**Fig. 9** zeigt in einer schematischen Darstellung das Elektronikmodul 30 von Fig. 7. Die Leistungselektronikeinheiten 32 werden über eine elektrische Leitung 51 mit Strom versorgt, und jede Leistungelektronikeinheit versorgt über eine elektrische Leitung 31 eine Ladesäule 80 mit elektrischer Energie.

Kühlmittelleitungen 71A sind mit den Leistungselektronikeinheiten 32 verbunden, um einen Kühlmittelfluss in Zusammenwirkung mit einem Kühlmodul 70 zu ermöglichen.

Das Kühlmittel wird zur Kühlung der Leistungselektronikeinheiten 32 verwendet, und über Kühlmittelleitungen 71B wird es von der jeweiligen Leistungselektronikeinheit 32 einer Ladesäule 80 zugeführt.

Bevorzugt sind die Anschlüsse für die elektrischen Leitungen 51, 31 und die Kühlmittelleitungen 71A, 71B alle an einer Seite des Gehäuses angeordnet und dort zugänglich, bevorzugt an der Vorderseite hinter dem Gehäusezugang.

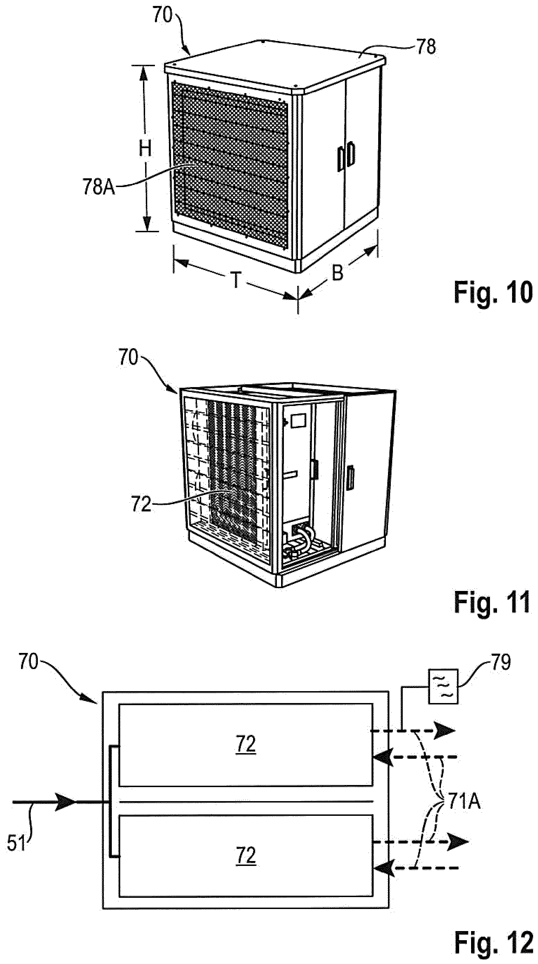

**Fig. 10** zeigt ein Kühlmodul 70 mit einem Kühlmodul-Gehäuse 78. Die Form und die Abmessungen des Kühlmodul-Gehäuses 78 entsprechen bevorzugt der Form und den Abmessungen des Elektronikmodul-Gehäuses 38 von Fig. 4. Eine Seitenwand 78A ist bevorzugt mit einem Gitter versehen, um eine gute Kühlung zu ermöglichen.

**Fig. 11** zeigt das Kühlmodul 70 von Fig. 10 mit teilweise entfernten Seitenwänden. Es ist eine Kühleinheit 72 zu sehen, die in etwa die Hälfte des Bauraums einnimmt.

**Fig. 12** zeigt in schematischer Darstellung den Aufbau des Kühlmoduls 70. Das Kühlmodul 70 hat mindestens eine Kühleinheit 72, im Ausführungsbeispiel hat es zwei Kühleinheiten 72, welche über eine elektrische Leitung 51 mit elektrischer Energie versorgt werden. Jede Kühleinheit 72 hat Kühlmittelleitungen 71A, über welche das Kühlmittel 79 zu einem Elektronikmodul 30 gefördert werden kann und auch von diesem zurück zur Kühleinheit 72 gelangen kann. Über die Kühlmittelleitungen 71A kann pro Kühleinheit 72 ein Kühlmittelkreislauf realisiert werden.

Bevorzugt sind die Anschlüsse für die elektrische Leitung 51 und die Kühlmittelleitungen 71A alle an einer Seite des Gehäuses angeordnet und dort zugänglich, bevorzugt an der Vorderseite hinter dem Gehäusezugang.

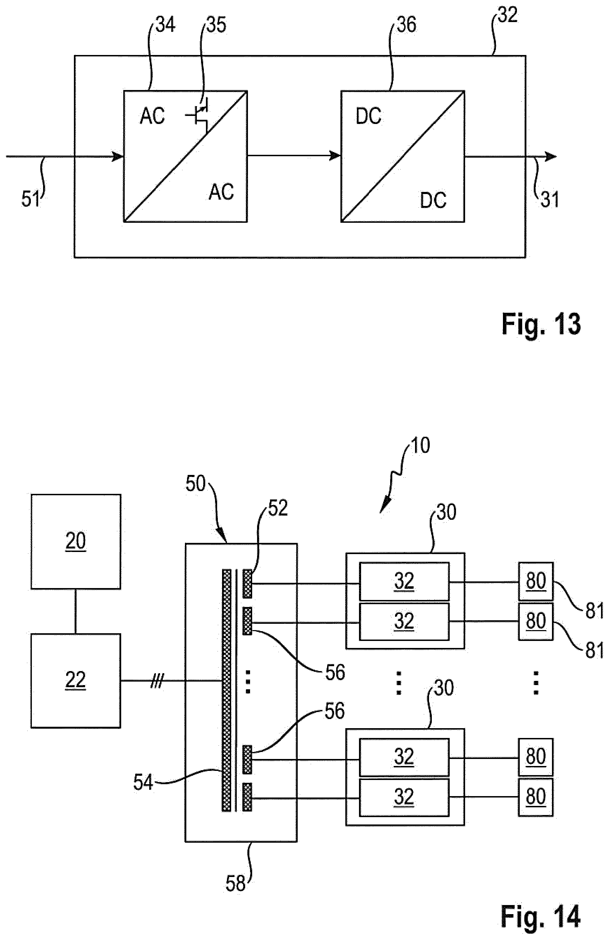

**Fig. 13** zeigt in schematischer Darstellung den Aufbau einer Leistungselektronikeinheit 32. Die Leistungselektronikeinheit 32 hat einen AC/DC-Wandler 34, der auch als Gleichrichter bezeichnet wird, und einen DC/DC-Wandler 36, der auch als Gleichspannungswandler bezeichnet wird. Über eine elektrische Leitung 51 wird der Leistungselektronikeinheit 32 vom Transformatormodul 50 (vgl. Fig. 2 und Fig. 3) ein Wechselstrom zugeführt, und dieser wird im AC/DC-Wandler 34 gleichgerichtet. Als AC/DC-Wandler 34 wird bevorzugt ein aktiver Gleichrichter verwendet, der auch eine Erhöhung der Eingangsspannung ermöglicht. Zudem ermöglicht ein aktiver AC/DC-Wandler 34 im Vergleich zu einem passiven AC/DC-Wandler 34 eine höhere Effizienz, geringere Oberschwingungen und einen besseren Leistungsfaktor.

Die gleichgerichtete Spannung wird über einen Gleichstromzwischenkreis dem DC/DC-Wandler zugeführt, und dieser ermöglicht eine Änderung der Amplitude der Gleichspannung. Im Normalfall führt der DC/DC-Wandler 36 eine Verringerung der Amplitude durch, es kann aber auch eine Erhöhung durchgeführt werden. Bei einer Verwendung eines aktiven AC/DC-Wandlers 34 wird bevorzugt ein DC/DC-Wandler 36 verwendet, der die Amplitude nur erniedrigen kann. Schematisch ist ein Halbleiterschalter 35 eingezeichnet, wie er für den AC/DC-Wandler 34 und/oder den DC/DC-Wandler 36 verwendet werden kann. Als Halbleiterschalter 35 wird bevorzugt ein Siliziumkarbid-Halbleiterschalter verwendet. Solche Halbleiterschalter haben den Vorteil, dass sie sehr schnell geschaltet werden können und vergleichsweise geringe Schaltverluste aufweisen. Hierdurch entsteht weniger Verlustleistung, und dies ermöglicht eine besonders kompakte Ausbildung der Leistungselektronikeinheiten 32.

Alternativ zu Siliziumkarbid-Halbleiterschaltern 35 können auch Gallium-Nitrid-Halbleiterschalter 35 verwendet werden. Gallium-Nitrid-Halbleiterschalter ermöglichen noch kleinere Bauformen. Hochwertige IGBT-Halbleiterschalter können insbesondere bei niedrigeren Leistungen genutzt werden.

Der AC/DC-Wandler 34 und der DC/DC-Wandler 36 sind bevorzugt ohne galvanische Trennung ausgebildet, es ist also keine galvanische Trennung zwischen der elektrischen Leitung 51 und der elektrischen Leitung 31 vorgesehen. Eine galvanische Trennung ist grundsätzlich mit Leistungsverlusten verbunden, und daher ermöglicht eine solche Ausbildung eine geringere Größe, und sie erfordert weniger Kühlung. Die galvanische Trennung kann wie beschrieben über den Transformator erreicht werden. Eine galvanische Trennung ist in einigen Ländern vorgeschrieben.

Die Leistungselektronikeinheit 32 ist bevorzugt dazu ausgebildet, die Versorgung eines Ladepunkts mit einer maximalen Ladeleistung zu ermöglichen, welche maximale Ladeleistung mindestens 60 kW beträgt, bevorzugt mindestens 300 kW beträgt, besonders bevorzugt mindestens 420 kW. Es kann also dann, wenn die Batterie mit einer sehr hohen Ladeleistung geladen werden kann, eine Leistung von mindestens 60 kW, mindestens 300 kW oder mindestens 420 kW erreicht werden. Dies erfordert eine leistungsstarke Leistungselektronikeinheit 32, und das Vorsehen zwei solcher Leistungselektronikeinheiten 32 in einem Elektronikmodul 30 hat sich als sehr vorteilhaft erwiesen, da die Abmessung des Elektronikmoduls 30 noch praktisch für einen Transport des Elektronikmoduls 30 ist. Es ist nicht zwingend ein Schwertransport erforderlich.

**Fig. 14** zeigt in schematischer Darstellung eine beispielhafte Zusammenschaltung der Vorrichtung 10 in elektrischer Hinsicht. Das Stromnetz 20 ist mit einer Schaltanlage 22 verbunden, und die Schaltanlage 22 ist elektrisch mit dem Transformatormodul 50 verbunden. Das Transformatormodul 50 hat einen Transformator 52 mit einer Primärwicklung 54 und einer Mehrzahl von Sekundärwicklungssystemen 56. Jedes Sekundärwicklungssystem 56 ist einer Leistungselektronikeinheit 32 und einem Ladepunkt 81 zugeordnet. Die Ausbildung des Transformators 52 mit einer Mehrzahl von galvanisch voneinander getrennten Sekundärwicklungssystemen ermöglicht die galvanische Trennung im Bereich des Transformators 52 und damit das Weglassen einer galvanischen Trennung im Bereich der Leistungselektronikeinheiten 32. Zudem kann ohne zusätzliche Beschaltung jede Leistungselektronikeinheit 32 über das ihr zugeordnete Sekundärwicklungssystem bedarfsgerecht Leistung aufnehmen. Dies beeinflusst den Gleichzeitigkeitsfaktor positiv.

Das Stromnetz 20 hat eine Eingangsspannung, die beispielsweise bis zu 36 kV betragen kann.

Die von den Leistungselektronikeinheiten gelieferte Ausgangsspannung kann beispielsweise bis zu 950 V betragen, und der Ausgangsstrom bis zu 500 A.

Es wird bevorzugt ein Transformator 52 verwendet, der für das Gesamtsystem einen Gleichzeitigkeitsfaktor ermöglicht, der größer als 0,85 ist, bevorzugt größer als 0,9 ist, und besonders bevorzugt 1,0 ist. Solche Transformatoren 52 sind zwar im Vergleich zu Standardtransformatoren teuer, sie ermöglichen jedoch eine kleinere Ausbildung der Module als ein Transformator, der für das Gesamtsystem bspw. nur einen Gleichzeitigkeitsfaktor von 0,6 ermöglicht. Vorteilhaft für einen hohen Gleichzeitigkeitsfaktor ist zudem, dass die Leistungselektronikeinheiten 32 jeweils für einen Ladepunkt verwendet werden und nicht mehrere Leistungselektronikeinheiten 32 für einen Ladepunkt zusammengeschaltet werden.

In einer bevorzugten Ausführungsform wird ein trockener Gießharztransformator genutzt, welcher ohne Beschädigung über mehrere Stunden oberhalb des Nennbetriebs betrieben werden kann. Die Leistungsbalance zwischen den Ladepunkten erfolgt bevorzugt über das Stromnetz und nicht durch das Zusammenschalten der Leistungselektronikeinheiten.

Beim Vorsehen einer galvanischen Trennung in den Leistungselektronikeinheiten wäre eine Zusammenschaltung der Netze hinter dem Transformator möglich, der Gleichzeitigkeitsfaktor würde jedoch sinken.

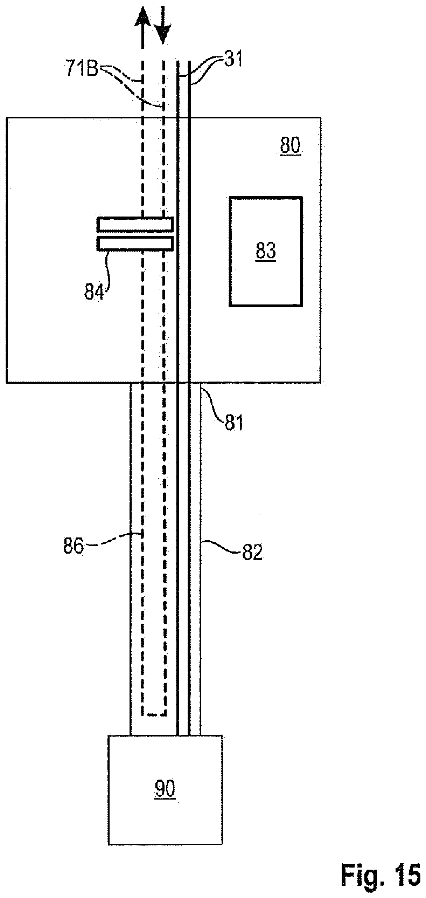

**Fig. 15** zeigt in schematischer Darstellung den Aufbau einer Ladesäule 80. Die Ladesäule 80 hat einen Wärmetauscher 84, welcher einerseits mit der Kühlmittelleitung 71B und andererseits mit einem Kühlkreislauf 86 verbunden ist. Ein Ladekabel 82 ist schematisch dargestellt und verläuft zur Ladedose einer Batterie 90 eines Fahrzeugs 14. Die elektrische Leitung 31 erstreckt sich entweder direkt in das Ladekabel 82 hinein, oder es sind in der Ladesäule 80 weitere Schalter oder Verteiler vorgesehen. Der Kühlkreislauf 86 ermöglicht eine Kühlung des elektrischen Leiters 31 und der Kontakte im Ladestecker und somit hohe Ladeströme. Der Kühlkreislauf 86 verläuft bevorzugt bis in den Ladestecker des Ladekabels 82. In der Ladesäule 80 ist eine Ladesäulen-Steuereinheit 83 vorgesehen, über welche der Ladevorgang gesteuert und eine Bedienung möglich ist.

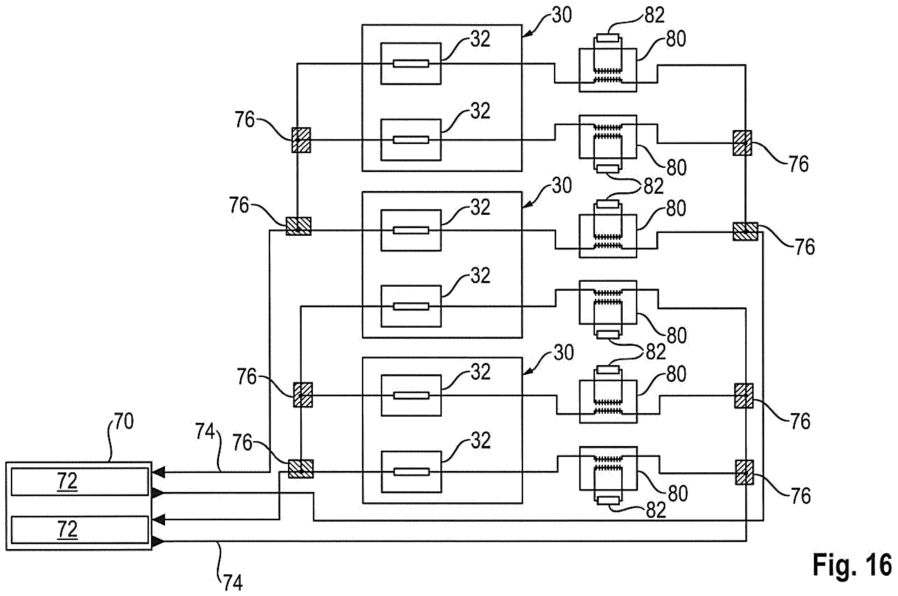

**Fig. 16** zeigt die fluidtechnische Verschaltung eines Kühlmoduls 70 mit zwei Kühleinheiten 72. Jede Kühleinheit 72 versorgt einen zugeordneten Kühlkreislauf 74, welcher jeweils drei parallel geschaltete Leistungselektronikeinheiten 32 umfasst. Das Kühlmittel fließt jeweils in einem Zweig durch eine Leistungselektronikeinheit 32 und durch eine Ladesäule 80, welche miteinander in Serie geschaltet sind. Hierbei sind beide Richtungen möglich.

Bevorzugt sind steuerbare Durchflusssteuerungsmittel 76 vorgesehen, um die Kühlleistung für die mindestens zwei parallel geschalteten Leistungselektronikeinheiten 32 im Verhältnis zueinander beeinflussen zu können. Bei den Durchflusssteuerungsmitteln 76 handelt es sich bspw. um Ventile, wie Drei-Weg-Ventile oder Vier-Weg-Ventile, oder es können im jeweiligen Zweig Stromventile vorgesehen werden, die den Durchflussquerschnitt verändern können. Die Durchflusssteuerungsmittel 76 können vor den einzelnen Zweigen mit einer Leistungselektronikeinheit 32 und einer Ladesäule 80 vorgesehen werden, oder hinter einem solchen Zweig, oder sowohl vor als auch hinter einem solchen Zweig.

Mit Hilfe der Durchflusssteuerungsmittel 76 kann die Kühlleistung für die einzelnen Zweige eingestellt werden, und wenn in einem Zweig eine große Ladeleistung verwendet wird, kann die Kühlleistung in diesem Zweig entsprechend erhöht werden.

Das Vorsehen von mindestens zwei Kühleinheiten 72 und die Verwendung der jeweiligen Kühlmittelkreisläufe 74 für unterschiedliche Leistungselektronikeinheiten 32 haben den Vorteil, dass auch dann, wenn eine der Kühleinheiten 72 ausfällt, weiterhin ein Teil der Ladesäulen 80 betrieben werden kann.

Naturgemäß sind im Rahmen der Erfindung vielfältige Abwandlungen und Modifikationen möglich.

Wenn in der Anmeldung von einer elektrischen Leitung gesprochen wird, kann diese einen Leiter oder auch mehrere Leiter aufweisen. Für einen Gleichstrom können beispielsweise zwei Leiter oder drei Leiter (mit Erdung) verwendet werden, und für einen Wechselstrom zwei, drei oder vier (mit Erdung) Leiter. Ebenso kann bei einer Kühlmittelleitung beispielsweise ein Rohr oder Schlauch vorgesehen werden, oder es können auch mehrere Rohre und/oder Schläuche vorgesehen werden, beispielsweise für einen Hinfluss und einen Rückfluss.

Die Kühlung der Leistungselektronikeinheiten 32 und der Ladesäule 80 können entweder direkt über eine Vorbeileitung des Kühlmittels erfolgen, oder es können zusätzliche Wärmetauscher und zusätzliche Kühlkreisläufe vorgesehen werden, wie es beispielsweise in Fig. 15 für die Ladesäule 80 gezeigt ist.

In den einzelnen Zweigen des Kühlkreislaufs können Rückschlagventile vorgesehen sein, um einen Kühlmittelfluss nur in eine Richtung zuzulassen.

## Patentansprüche

1. Vorrichtung (10) zum Laden mindestens einer Batterie (90), insbesondere einer Traktionsbatterie für ein Fahrzeug (14),
welche Vorrichtung ein Elektronikmodul (30) und mindestens zwei Ladesäulen (80) mit einem Ladepunkt (81) aufweist,
welches Elektronikmodul (30) mindestens zwei Leistungselektronikeinheiten (32) aufweist,
welche Leistungselektronikeinheiten (32) einen AC/DC-Wandler (34) und einen DC/DC-Wandler (36) aufweisen,
wobei das Elektronikmodul (30) und die mindestens zwei Ladesäulen (80) räumlich voneinander getrennt sind, wobei die Vorrichtung ein Kühlmodul (70) aufweist,
welches Kühlmodul (70) dazu ausgebildet ist, ein flüssiges Kühlmittel (79) in einem Kühlmittelkreislauf (74) zu fördern,
welches Kühlmodul (70) mindestens zwei Kühleinheiten (72) aufweist, welche jeweils einem separaten Kühlmittelkreislauf (74) zugeordnet sind, **dadurch gekennzeichnet, dass** die mindestens zwei Kühleinheiten (72) fluidtechnisch mit unterschiedlichen Ladesäulen (80) und Leistungselektronikeinheiten (32) verbunden sind, um beim Ausfall einer der mindestens zwei Kühleinheiten (72) die Kühlung von mindestens einem Teil der Leistungselektronikeinheiten (32) und Ladesäulen (80) zu ermöglichen, und
welches Kühlmodul (70) fluidtechnisch mit mindestens zwei parallel geschalteten Leistungselektronikeinheiten (32) zu einem Kühlmittelkreislauf (74) geschaltet ist, wobei steuerbare Durchflusssteuerungsmittel (76) vorgesehen sind, um die Kühlleistung für die mindestens zwei parallel geschalteten Leistungselektronikeinheiten (32) im Verhältnis zueinander beeinflussen zu können.

2. Vorrichtung nach Anspruch 1, bei welcher die mindestens zwei Leistungselektronikeinheiten (32) dazu ausgebildet sind, jeweils genau einen Ladepunkt (81) mit einer Gleichspannung zu versorgen.

3. Vorrichtung nach Anspruch 1 oder 2, bei welcher die mindestens zwei Leistungselektronikeinheiten (32) Halbleiterschalter (35) aufweisen, welche als Siliziumkarbid-Halbleiterschalter ausgebildet sind.

4. Vorrichtung nach einem der vorhergehenden Ansprüche, bei welcher der AC/DC-Wandler (34) und der DC/DC-Wandler (36) ohne galvanische Trennung ausgebildet sind.

5. Vorrichtung nach einem der Ansprüche 3 oder 4, bei welcher der Wirkungsgrad der Leistungselektronikeinheiten (32) zumindest zeitweise mindestens 97 % beträgt.

6. Vorrichtung nach einem der vorhergehenden Ansprüche, bei welcher das Elektronikmodul (30) in einem Elektronikmodul-Gehäuse (38) angeordnet ist, dessen Höhe (H) kleiner als 1,5 m ist, bevorzugt kleiner als 1,35 m.

7. Vorrichtung nach einem der vorhergehenden Ansprüche, bei welcher das Elektronikmodul (30) eine Mehrzahl von Leistungselektronik-Untereinheit-Aufnahmen (40) aufweist, welche Leistungselektronik-Untereinheit-Aufnahmen (40) jeweils zur Aufnahme einer Leistungselektronik-Untereinheit (33) ausgebildet sind, wobei die Leistungselektronikeinheit (32) verwendbar ist, wenn in mindestens einer der Leistungselektronik-Untereinheit-Aufnahmen (40) eine Leistungselektronik-Untereinheit (33) angeordnet ist.

8. Vorrichtung nach Anspruch 7, bei welcher das Elektronikmodul (30) ein Elektronikmodul-Gehäuse (38) aufweist, welches Elektronikmodul-Gehäuse (38) an einer Seite einen Elektronikmodul-Gehäusezugang (39) aufweist, über welchen die Aufnahmen (40) für die Leistungselektronik-Untereinheiten (32) zugänglich sind, um eine Wartung zu ermöglichen.

9. Vorrichtung nach einem der vorhergehenden Ansprüche, bei welcher die mindestens zwei Leistungselektronikeinheiten (32) jeweils dazu ausgebildet sind, die Versorgung eines Ladepunkts mit einer maximalen Ladeleistung zu ermöglichen, welche maximale Ladeleistung mindestens 60 kW beträgt, bevorzugt mindestens 300 kW beträgt, besonders bevorzugt mindestens 420 kW beträgt.

10. Vorrichtung nach einem der vorhergehenden Ansprüche, welche ein Transformatormodul (50) mit einem Transformator (52) aufweist.

11. Vorrichtung nach Anspruch 10, bei welcher das Transformatormodul (50) räumlich getrennt ist vom Elektronikmodul (30).

12. Vorrichtung nach Anspruch 10 oder 11, bei welcher der Transformator (52) eine Primärwicklung (54) und mehrere voneinander galvanisch getrennte Sekundärwicklungssysteme (56) aufweist, welche Sekundärwicklungssysteme (56) jeweils genau einer der Leistungselektronikeinheiten (32) zugeordnet sind, wobei die Sekundärwicklungssysteme (56) bevorzugt als dreiphasige Sekundärwicklungssysteme in Stern- oder Dreieckskonfiguration ausgebildet sind.

13. Vorrichtung nach einem der Ansprüche 10 bis 12, bei welcher der Transformator (52) dazu ausgebildet ist, für das Gesamtsystem einen Gleichzeitigkeitsfaktor zu ermöglichen, der größer als 0,85 ist, bevorzugt größer als 0,9 ist und besonders bevorzugt 1,0 ist.

14. Vorrichtung nach einem der Ansprüche 10 bis 13, bei welcher das Transformatormodul (50) ein Transformatormodul-Gehäuse (58) aufweist, und bei welcher das Elektronikmodul (30) ein Elektronikmodul-Gehäuse (38) aufweist, wobei das Transformatormodul-Gehäuse (58) und das Elektronikmodul-Gehäuse (38) die gleiche Form und die gleichen Abmessungen aufweisen.

15. Vorrichtung nach einem der vorhergehenden Ansprüche, bei welcher das Kühlmodul (70) und das Elektronikmodul (30) räumlich voneinander getrennt sind.

16. Vorrichtung nach einem der vorhergehenden Ansprüche, bei welcher das Kühlmodul (80) fluidtechnisch mit dem Elektronikmodul (30) verbunden ist, um eine Kühlung des Elektronikmoduls (30) zu ermöglichen.

17. Vorrichtung nach einem der vorhergehenden Ansprüche, bei welcher das Elektronikmodul (30) fluidtechnisch mit mindestens einer Ladesäule (80) verbunden ist, um einen Kühlmittelfluss vom Elektronikmodul (30) zur Ladesäule (80) oder einen Kühlmittelfluss von der Ladesäule (80) zum Elektronikmodul (30) oder einen Kühlmittelfluss in beide Richtungen zu ermöglichen.

18. Vorrichtung nach einem der vorhergehenden Ansprüche, bei welcher die mindestens zwei Ladesäulen (80) ein Ladekabel (82) und einen Wärmetauscher (84) aufweisen, und bei welcher das Kühlmodul (70) fluidtechnisch mit dem Wärmetauscher (84) verbunden ist, um mit Hilfe des Wärmetauschers (84) eine Kühlung des Ladekabels (82) zu ermöglichen.

19. Vorrichtung nach einem der vorhergehenden Ansprüche, bei welcher das Kühlmodul (80)fluidtechnisch derart mit einer der Leistungselektronikeinheiten (32) und einer dieser Leistungselektronikeinheit (32) zugeordneten Ladesäule (80) verbunden ist, dass ein Kühlmittelkreislauf (74) vom Kühlmodul (70) über die Ladesäule (80) und über die der Ladesäule (80) zugeordnete Leistungselektronikeinheit (32) zurück zum Kühlmodul (70) ermöglicht ist, oder umgekehrt.

20. Vorrichtung nach einem der vorhergehenden Ansprüche, bei welcher jede der mindestens zwei Kühleinheiten (74) für maximal drei Leistungselektronikeinheiten (32) und Ladepunkte (81) ausgebildet ist.

21. Vorrichtung nach einem der vorhergehenden Ansprüche, bei welcher das Kühlmodul (70) in einem Kühlmodul-Gehäuse (78) angeordnet ist, dessen Höhe (H) kleiner als 1,5 m ist, bevorzugt kleiner als 1,35 m.

22. Vorrichtung nach einem der vorhergehenden Ansprüche, bei welcher das Kühlmodul (70) ein Kühlmodul-Gehäuse (78) aufweist, und bei welcher das Elektronikmodul (30) ein Elektronikmodul-Gehäuse (38) aufweist, wobei das Kühlmodul-Gehäuse (78) und das Elektronikmodul-Gehäuse (38) die gleiche Form und die gleichen Abmessungen aufweisen.

## Claims

1. Device (10) for charging at least one battery (90), in particular a traction battery for a vehicle (14), which device has an electronics module (30) and at least two charging pillars (80) with a charging point (81), which electronics module (30) has at least two power electronics units (32),
which power electronics units (32) have an AC/DC converter (34) and a DC/DC converter (36),
wherein the electronics module (30) and the at least two charging pillars (80) are spatially separate from one another,
wherein
the device has a cooling module (70),
which cooling module (70) is designed to convey a liquid coolant (79) in a coolant circuit (74),
which cooling module (70) has at least two cooling units (72) which are each assigned to a separate coolant circuit (74),
**characterized in that**
the at least two cooling units (72) are fluidically connected to different charging pillars (80) and power electronics units (32) in order to permit at least some of the power electronics units (32) and charging pillars (80) to be cooled when one of the at least two cooling units (72) fails, and
which cooling module (70) is fluidically connected to at least two power electronics units (32), connected in parallel, to form a coolant circuit (74), wherein controllable through-flow control means (76) are provided in order to be able to influence in relation to one another the cooling power for the at least two power electronics units (32) which are connected in parallel.

2. Device according to Claim 1, in which the at least two power electronics units (32) are designed to supply in each case precisely one charging point (81) with a direct voltage.

3. Device according to Claim 1 or 2, in which the at least two power electronics units (32) have semiconductor switches (35) which are embodied as silicon carbide semiconductor switches.

4. Device according to one of the preceding claims, in which the AC/DC converter (34) and the DC/DC converter (36) are embodied without galvanic isolation.

5. Device according to one of Claims 3 and 4, in which the efficiency level of the power electronics units (32) is at least temporally at least 97%.

6. Device according to one of the preceding claims, in which the electronics module (30) is arranged in an electronics module housing (38) whose height (H) is less than 1.5 m, preferably less than 1.35 m.

7. Device according to one of the preceding claims, in which the electronics module (30) has a multiplicity of power electronics sub-unit receptacles (40), which power electronics sub-unit receptacles (40) are each designed to receive a power electronics sub-unit (33), wherein the power electronics unit (32) can be used if a power electronics sub-unit (33) is arranged in at least one of the power electronics sub-unit receptacles (40).

8. Device according to Claim 7, in which the electronics module (30) has an electronics module housing (38), which electronics module housing (38) has on one side an electronics module housing access (39) via which the receptacles (40) for the power electronics sub-units (32) can be accessed in order to permit maintenance.

9. Device according to one of the preceding claims, in which the at least two power electronics units (32) are each designed to permit a charging point to be supplied with a maximum charging capacity, which maximum charging capacity is at least 60 kW, preferably at least 300 kW, particularly preferably at least 420 kW.

10. Device according to one of the preceding claims, which has a transformer module (50) with a transformer (52).

11. Device according to Claim 10, in which the transformer module (50) is spatially separate from the electronics module (30).

12. Device according to Claim 10 or 11, in which the transformer (52) has a primary winding (54) and a plurality of secondary winding systems (56) which are galvanically separate from one another, which secondary winding systems (56) are each assigned to precisely one of the power electronics units (32), wherein the secondary winding systems (56) are preferably embodied as three-phase secondary winding systems in a star or delta configuration.

13. Device according to one of Claims 10 to 12, in which the transformer (52) is designed to permit a simultaneity factor for the entire system which is higher than 0.85, preferably higher than 0.9 and is particularly preferably 1.0.

14. Device according to one of Claims 10 to 13, in which the transformer module (50) has a transformer module housing (58), and in which the electronics module (30) has an electronics module housing (38), wherein the transformer module housing (58) and the electronics module housing (38) have the same shape and the same dimensions.

15. Device according to one of the preceding claims, in which the cooling module (70) and the electronics module (30) are spatially separate from one another.

16. Device according to one of the preceding claims, in which the cooling module (80) is fluidically connected to the electronics module (30) in order to permit the electronics module (30) to be cooled.

17. Device according to one of the preceding claims, in which the electronics module (30) is fluidically connected to at least one charging pillar (80) in order to permit a flow of coolant from the electronics module (30) to the charging pillar (80), or a flow of coolant from the charging pillar (80) to the electronics module (30) or a flow of coolant in both directions.

18. Device according to one of the preceding claims, in which the at least two charging pillars (80) have a charging cable (82) and a heat exchanger (84), and in which the cooling module (70) is fluidically connected to the heat exchanger (84) in order to permit the charging cable (82) to be cooled using the heat exchanger (84).

19. Device according to one of the preceding claims, in which the cooling module (80) is fluidically connected to one of the power electronics units (32) and a charging pillar (80) which is assigned to this power electronics unit (32) in such a way that a coolant circuit (74) from the cooling module (70) via the charging pillar (80) and via the power electronics unit (32) assigned to the charging pillar (80) and back to the cooling module (70), or vice versa, is made possible.

20. Device according to one of the preceding claims, in which each of the at least two cooling units (74) is designed for at maximum three power electronics units (32) and charging points (81).

21. Device according to one of the preceding claims, in which the cooling module (70) is arranged in a cooling module housing (78) whose height (H) is less than 1.5 m, preferably less than 1.35 m.

22. Device according to one of the preceding claims, in which the cooling, module (70) has a cooling module housing (78), and in which the electronics module (30) has an electronics module housing (38), wherein the cooling module housing (78) and the electronics module housing (38) have the same shape and the same dimensions.

## Revendications

1. Dispositif (10) de charge d'au moins une batterie (90), en particulier d'une batterie de traction d'un véhicule (14),
lequel dispositif comporte un module électronique (30) et au moins deux colonnes de charge (80) pourvues d'un point de charge (81),
lequel module électronique (30) comporte au moins deux unités d'électronique de puissance (32),
lesquelles unités d'électronique de puissance (32) comportent un convertisseur alternatif/continu (34) et un convertisseur continu/continu (36),
le module électronique (30) et les au moins deux colonnes de charge (80) étant spatialement séparés les uns des autres,
le dispositif comportant un module de refroidissement (70), lequel module de refroidissement (70) est conçu pour transporter un agent de refroidissement liquide (79) dans un circuit d'agent de refroidissement (74), lequel module de refroidissement (70) comporte au moins deux unités de refroidissement (72) qui sont chacune associées a un circuit d'agent de refroidissement séparé (74),
**caractérisé en ce que** les au moins deux unités de refroidissement (72) sont reliées fluidiquement à différentes colonnes de charge (80) et unités d'électronique de puissance (32) pour permettre, en cas de défaillance de l'une des au moins deux unités de refroidissement (72), le refroidissement d'au moins une partie des unités d'électronique de puissance (32) et des colonnes de charge (80), et
lequel module de refroidissement (70) est relié fluidiquement à au moins deux unités d'électronique de puissance (32), montées en parallèle, pour former un circuit d'agent de refroidissement (74),
lesdits moyens de commande de débit commandables (76) étant prévus pour pouvoir influer sur la capacité de refroidissement des au moins deux unités d'électronique de puissance (32), montées en parallèle, l'une par rapport à l'autre.

2. Dispositif selon la revendication 1, dans lequel les au moins deux unités d'électronique de puissance (32) sont conçues pour alimenter exactement un point de charge (81) en tension continue.

3. Dispositif selon la revendication 1 ou 2, dans lequel les au moins deux unités d'électronique de puissance (32) comportent des commutateurs à semi-conducteurs (35) qui sont réalisés sous la forme de commutateurs à semi-conducteurs au carbure de silicium.

4. Dispositif selon l'une des revendications précédentes, dans lequel le convertisseur alternatif/continu (34) et le convertisseur continu/continu (36) sont réalisés sans séparation galvanique.

5. Dispositif selon l'une des revendications 3 et 4, dans lequel le rendement des unités d'électronique de puissance (32) est au moins temporairement d'au moins 97 %.

6. Dispositif selon l'une des revendications précédentes, dans lequel le module électronique (30) est disposé dans un boîtier de module électronique (38) dont la hauteur (H) est inférieure à 1,5 m, de préférence inférieure à 1,35 m.

7. Dispositif selon l'une des revendications précédentes, dans lequel le module électronique (30) comporte une pluralité de logements de sous-unités d'électronique de puissance (40), lesquels logements de sous-unités d'électronique de puissance (40) sont conçus chacun pour loger une sous-unité d'électronique de puissance (33), l'unité d'électronique de puissance (32) pouvant être utilisée si une sous-unité d'électronique de puissance (33) est disposée dans l'un au moins des logements de sous-unité d'électronique de puissance (40).

8. Dispositif selon la revendication 7, dans lequel le module électronique (30) comporte un boîtier de module électronique (38), lequel boîtier de module électronique (38) comporte d'un côté un accès au boîtier de module électronique (39) permettant d'accéder aux logements (40) destinés aux sous-unités d'électronique de puissance (32) pour permettre la maintenance.

9. Dispositif selon l'une des revendications précédentes, dans lequel les au moins deux unités d'électronique de puissance (32) sont chacune conçues pour permettre l'alimentation d'un point de charge en puissance de charge maximum, laquelle puissance de charge maximale est d'au moins 60 kW, de préférence d'au moins 300 kW, de manière particulièrement préférée d'au moins 420 kW.

10. Dispositif selon l'une des revendications précédentes, lequel comporte un module transformateur (50) pourvu d'un transformateur (52).

11. Dispositif selon la revendication 10, dans lequel le module transformateur (50) est spatialement séparé du module électronique (30).

12. Dispositif selon la revendication 10 ou 11, dans lequel le transformateur (52) comporte un enroulement primaire (54) et une pluralité de systèmes d'enroulement secondaire (56) séparés galvaniquement les uns des autres, lesquels systèmes d'enroulement secondaire (56) sont chacun associés à exactement une des unités d'électronique de puissance (32), les systèmes d'enroulement secondaire (56) étant de préférence conçus comme des systèmes d'enroulement secondaire triphasés dans une configuration en étoile ou en triangle.

13. Dispositif selon l'une des revendications 10 à 12, dans lequel le transformateur (52) est conçu pour permettre, pour l'ensemble du système, un facteur de simultanéité supérieur à 0,85, de préférence supérieur à 0,9 et de manière particulièrement préférée de 1,0.

14. Dispositif selon l'une des revendications 10 à 13, dans lequel le module transformateur (50) comporte un boîtier de module transformateur (58), et dans lequel le module électronique (30) comporte un boîtier de module électronique (38), le boîtier de module transformateur (58) et le boîtier de module électronique (38) ayant la même forme et les mêmes dimensions.

15. Dispositif selon l'une des revendications précédentes, dans lequel le module de refroidissement (70) et le module électronique (30) sont spatialement séparés l'un de l'autre.

16. Dispositif selon l'une des revendications précédentes, dans lequel le module de refroidissement (80) est relié fluidiquement au module électronique (30) pour permettre le refroidissement du module électronique (30).

17. Dispositif selon l'une des revendications précédentes, dans lequel le module électronique (30) est relié fluidiquement à au moins une colonne de charge (80) pour permettre un flux d'agent de refroidissement allant du module électronique (30) à la colonne de charge (80) ou un flux d'agent de refroidissement allant de la colonne de charge (80) au module électronique (30) ou un flux d'agent de refroidissement dans les deux sens.

18. Dispositif selon l'une des revendications précédentes, dans lequel les au moins deux colonnes de charge (80) comportent un câble de charge (82) et un échangeur de chaleur (84), et dans lequel le module de refroidissement (70) est relié fluidiquement à l'échangeur de chaleur (84) pour permettre le refroidissement du câble de charge (82) à l'aide de l'échangeur de chaleur (84).

19. Dispositif selon l'une des revendications précédentes, dans lequel le module de refroidissement (80) est relié fluidiquement à l'une des unités d'électronique de puissance (32) et à une colonne de charge (80) associée à cette unité d'électronique de puissance (32) de façon à former un circuit d'agent de refroidissement (74) partant du module de refroidissement (70), passant par la colonne de charge (80) et l'unité d'électronique de puissance (32) associée à la colonne de charge (80) et revenant au module de refroidissement (70), ou inversement.

20. Dispositif selon l'une des revendications précédentes, dans lequel chacune des au moins deux unités de refroidissement (74) est conçue pour un maximum de trois unités d'électronique de puissance (32) et points de charge (81).

21. Dispositif selon l'une des revendications précédentes, dans lequel le module de refroidissement (70) est disposé dans un boîtier de module de refroidissement (78) dont la hauteur (H) est inférieure à 1,5 m, de préférence inférieure à 1,35 m.

22. Dispositif -selon l'une des revendications précédentes, dans lequel le module de refroidissement (70) comporte un boîtier de module de refroidissement (78), et dans lequel le module électronique (30) comporte un boîtier de module électronique (38), le boîtier de module de refroidissement (78) et le boîtier de module électronique (38) ayant la même forme et les mêmes dimensions.
